# EUROPÄISCHE PATENTSCHRIFT

(11) **EP 1 680 949 B1**
(45) Veröffentlichungstag und Bekanntmachung des Hinweises auf die Patenterteilung: **27.04.2011**
(21) Anmeldenummer: 04797569.3
(22) Anmeldetag: 03.11.2004
(51) Int. Cl.: H05K 3/34, H01L 23/485, H01L 21/60

(54) **Verfahren zur Herstellung einer Lötstoppbarriere**
Method for producing a solder stop barrier
Procédé de fabrication d'une barrière d'arrêt de brasure

(30) Priorität: 03.11.2003 DE 10351120
(43) Veröffentlichungstag der Anmeldung: 19.07.2006
(73) Patentinhaber: Infineon Technologies AG, 85579 Neubiberg (DE)
(72) Erfinder: LENNIGER, Andreas, 59609 Anröchte (DE)
(74) Vertreter: Schmuckermaier, Bernhard
(86) Internationale Anmeldenummer: PCT/EP2004/012436
(87) Internationale Veröffentlichungsnummer: WO 2005/043966

(56) Entgegenhaltungen:
- WO-A-03/071842
- US-A- 5 825 093
- ANONYMOUS: "Laser defined solderable area for circuit boards" RESEARCH DISCLOSURE, KENNETH MASON PUBLICATIONS, HAMPSHIRE, GB, Bd. 433, Nr. 8, Mai 2000 (2000-05), XP007126054 ISSN: 0374-4353
- PATENT ABSTRACTS OF JAPAN Bd. 014, Nr. 374 (E-0964), 13. August 1990 (1990-08-13) & JP 02 135767 A (HITACHI LTD), 24. Mai 1990 (1990-05-24)

## Beschreibung

Die Erfindung betrifft ein Verfahren zur Herstellung einer Lötstoppbarriere.

Derartige Lötstoppbarrieren werden üblicherweise bei der Herstellung elektronischer Komponenten, beispielsweise bei selektiven Lötungen auf ganzflächig benetzenden Oberflächen, eingesetzt. Dabei kann es dazu kommen, dass das Lot unbeabsichtigt die Lötstoppbarriere überwindet, beispielsweise, wenn die Lötstoppbarriere vor oder während des Lötvorgangs beschädigt wurde oder sich von der Oberfläche abgelöst hat. Zudem entsteht durch auslaufendes Lot eine Strömung, durch die ein anzulötendes Element verschwimmen und damit dejustiert werden kann.

Ganz ohne Lötstoppbarriere würde das flüssige und verlaufende Lot einen Bereich benetzen, dessen Größe von vielen physikalischen und chemischen Eigenschaften der Oberfläche und des Lotes abhängt. Eine gezielte Begrenzung der benetzten Bereiche durch Prozessparameter ist prozesssicher kaum möglich.

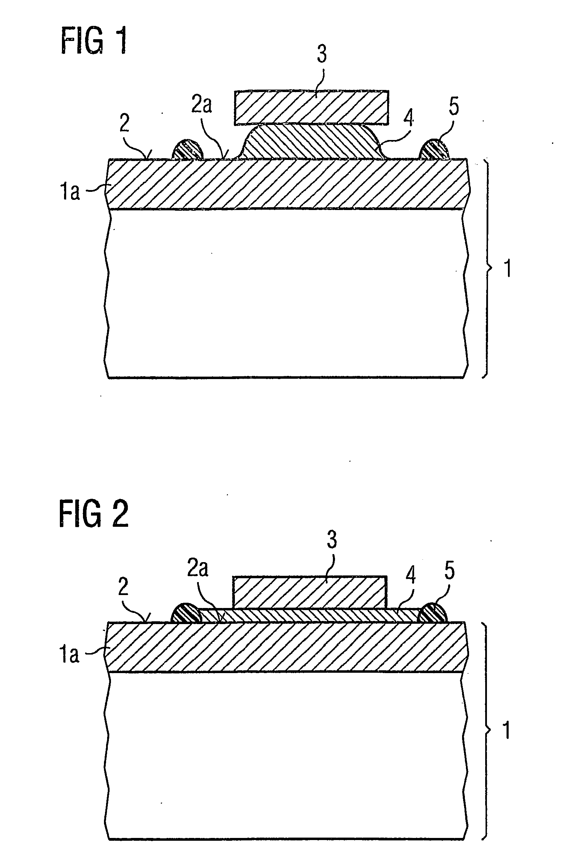

Bisher bekannte Lötstoppbarrieren werden regelmäßig durch Verwendung zusätzlicher Materialien wie beispielsweise Lötstopplacke realisiert. Ein typisches Beispiel einer Lötstoppbarriere gemäß dem Stand der Technik ist in Figur 1 gezeigt.

Ein bevorzugst als ebene Platte ausgebildeter keramischer Träger 1 ist mit einer metallischen Beschichtung 1a versehen. Auf einen Abschnitt 2a der Oberfläche 2 des Trägers 1 soll ein Substrat 3 gelötet werden. Dazu wird auf die Oberfläche 2 ein Strang aus Lötstopplack 5 aufgebracht, der den als Lötfläche vorgesehenen Abschnitt 2a der Oberfläche 2 begrenzt. Nun wird auf die vorgesehene Lötfläche 2a ein nicht flüssiges Lot 4, beispielsweise ein Lötplättchen oder eine Lötpaste, aufgebracht. Anschießend wird die Anordnung vollständig oder lokal über den Schmelzpunkt des Lotes 4 erhitzt, so dass sich dieses verflüssigt und - wie in Figur 2 darstellt - bis zu der durch den Lötstopplack 5 vorgegebenen Grenze verläuft.

Eine weitere Möglichkeit zur Realisierung einer mechanischen Lötstoppbarriere besteht in der ätztechnischen Strukturierung der Trägeroberfläche, wie dies in bekannter Weise bei der Herstellung elektrischer Leiterplatten erfolgt.

Die Publikation "Laser defined solderable area for circuit boards", Research Disclosure, Kenneth Mason Publications, Hampshire, Bd. 433, Nr. 8, Mai 2000, ISSN: 0374-4353 beschreibt, eine Lötfläche mittels Laser-Ablation zu definieren. Eine ähnliche Methode ist in der JP 02-135767 beschrieben.

Neben den mechanischen Lösungen zur Verhinderung des Verfließens eines flüssigen Lotes aus einem vorbestimmten Bereich werden auch noch Verfahren angewendet, die bestimmte Prozessfester einschränken. Als Beispiel hierfür seien eine reduzierte Löttemperatur oder eine lokale Erhitzung im Bereich der Lötfläche genannt.

Eine weitere Möglichkeit, die Benetzung bestimmter Bereiche mit auslaufendem Lot zu hemmen, besteht darin, diese Bereiche zum Beispiel galvanisch so zu behandeln, dass die Adhäsionskräfte zwischen dem Lot und der Lötfläche geringer sind als die Kohäsionskräfte innerhalb des Lotes, so dass sich die Benetzbarkeit der Lötfläche verringert.

Der Nachteil dieser Verfahren besteht darin, dass sie aufwändige Arbeitsgänge erfordern, dass zusätzliche Materialien benötigt werden, die oft keine ausreichende Temperaturbeständigkeit aufweisen und sich außerdem vom Träger ablösen können, oder dass Prozessfenster schwer eingestellt und eingehalten werden können.

Aufgabe der vorliegenden Erfindung ist es daher, ein einfach anzuwendendes Verfahren zur Herstellung einer Lötstoppbarriere vorzustellen, das keine zusätzlich auf die Trägeroberfläche aufgebrachten Materialien erfordert und die ein hohes Maß an Zuverlässigkeit aufweisen.

Diese Aufgabe wird erfindungsgemäß durch ein Verfahren Anspruch 1 gelöst. Bevorzugte Ausführungsformen und Weiterbildungen der Erfindung sind Gegenstand von Unteransprüchen.

Bei dem erfindungsgemäßen Verfahren zur Herstellung einer Lötstoppbarriere wird zunächst ein Träger bereitgestellt. Danach wird auf der Oberfläche des Trägers durch Einwirkung eines Laserstrahls vertiefungsfrei eine Lötstoppbarriere erzeugt, die ein flüssiges, auf der Oberfläche befindliches Lot daran hindern soll, über eine durch die Lötstoppbarriere vorgegebene Grenze hinwegzufließen.

Die Lötstoppbarriere umfasst wenigstens eine an der Oberfläche des Trägers angeordnete Lötstoppspur, die einen Abschnitt der Oberfläche, der mit Lot benetzt werden soll, von einem anderen Abschnitt der Oberfläche, der nicht mit Lot benetzt werden soll, trennt.

Zur Herstellung der wenigstens einen Lötstoppspur wird auf der Oberfläche des Trägers durch Einwirkung eines Laserstrahls entlang eines Pfades auf der Oberfläche eine chemische Veränderung herbeigeführt, die die Benetzbarkeit der Oberfläche des Trägers mit flüssigem Lot im Bereich des Pfades lokal reduziert.

Diese reduzierte Benetzbarkeit resultiert aus der chemischen Veränderung der Trägeroberfläche, beispielsweise wenn die wenigstens zwei chemischen Stoffe derart miteinander reagieren, dass auf dem Träger in dem mit dem Laser behandelten Bereich ein Reaktionsprodukt zurückbleibt, das eine im Vergleich zu dem unbehandelten Träger reduzierte Benetzbarkeit mit flüssigem Lot aufweist.

Eine derartige chemische Veränderung kann beispielsweise eine Oxidation sein, bei der Luft-Sauerstoff aus der Umgebungsluft des Trägers mit einem Trägermaterial reagiert. Anstelle von normaler Umgebungsluft kann der Träger auch zumindest während der Einwirkung des Laserstrahls in eine geeignete Atmosphäre, z.B. in ein Prozessgas, eingebracht werden, die einen oder mehrere geeignete Reaktionspartner aufweist, welche unter Einwirkung des Laserstrahls mit wenigstens einem Material des Trägers in dem bestrahlten Bereich zu einer die Benetzbarkeit des Trägers mit flüssigem Lot reduzierenden Reaktion führt. Anstelle oder zusätzlich zu einer speziellen Atmosphäre können solche Reaktionspartner auch in fester, pastenartiger oder flüssiger Form auf den Träger aufgebracht und durch die Einwirkung des Lasers zu einer Reaktion mit einem Material des Trägers gebracht werden. Gleichzeitig soll ein Materialabtrag von der Trägeroberfläche durch die Einwirkung des Laserstrahls so weit wie möglich vermieden werden.

Als dem Träger entstammende Reaktionspartner eignen sich beispielsweise Nickel, Kupfer, Titan oder eine Legierung dieser Elemente.

Die Auswirkung des Laserstrahls bei der Herstellung einer Lötstoppbarriere kann durch die Wahl geeigneter Prozessparameter beeinflusst werden.

Hierzu zählen insbesondere Eigenschaften des Laserstrahls wie Wellenlänge, mittlere Leistung, Spitzenleistung, Pulsenergie, Pulsdauer, Pulsfolge, Querschnittsprofil, Intensitätsverteilung über den Strahlquerschnitt, Einfallswinkel gegenüber der Trägeroberfläche oder die Fortschrittsgeschwindigkeit des Auftreffpunktes des Laserstrahls auf der Trägeroberfläche. Bevorzugt wird zur Herstellung einer Lötstoppbarriere ein gepulster Laserstrahl, beispielsweise ein Infrarot-Laserstrahl, z.B. ein NdYAG-Laserstrahl mit einer Wellenlänge von 1064 nm, verwendet.

Ebenso wie der Laserstrahl beeinflussen auch das Trägermaterial, das Material einer eventuellen Beschichtung des Trägers, insbesondere die oberste von gegebenenfalls mehreren Beschichtungsebenen sowie die den Träger umgebende Atmosphäre das Resultat bei der Herstellung einer Lötstoppbarriere.

Die relevanten Prozessparameter sind bevorzugt so gewählt, dass das Material des Trägers durch die Einwirkung des Laserstrahls nicht oder nur minimal abgetragen wird, so dass die Geometrie der Trägeroberfläche im Wesentlichen unverändert bleibt. Dabei kann die Oberfläche im Bereich der Lötstoppspur vorübergehend aufgeschmolzen werden.

Durch eine erfindungsgemäße Lötstoppbarriere ist es möglich, eine vorgesehene Lötfläche gegenüber einem Bereich, der nicht von flüssigem Lot benetzt werden soll, abzugrenzen. Dabei kann der Verlauf einer Lötstoppbarriere an der Oberfläche des Trägers beliebig gewählt sein.

Gemäß einer bevorzugten Ausführungsform der Erfindung ist eine Lötstoppbarriere als durchgehende, geschlossene Kurve ausgebildet, die eine vorgesehene Lötfläche umschließt. Die Lötstoppbarriere kann jedoch ebenso nur abschnittweise hergestellt sein, beispielsweise um das Abfließen des flüssigen Lotes in bestimmte Richtungen zu unterbinden. Des weiteren kann die Lötstoppbarriere Überschneidungen mit sich selbst oder mit anderen Lötstoppbarrieren aufweisen.

Im einfachsten Fall besteht eine erfindungsgemäße Lötstoppbarriere aus einer einzelnen, durchgehenden Lötstoppspur. Zur Erhöhung der Prozesssicherheit kann eine Lötstoppbarriere jedoch auch mehrere nebeneinander angeordnete Lötstoppspuren aufweisen.

Gemäß eines Aspekts der Erfindung verlaufen dabei zwei, drei oder mehr Lötstoppspuren einer Lötstoppbarriere parallel. Die Lötstoppspuren können dabei über ihre gesamte Länge oder zumindest abschnittweise voneinander beabstandet sein, aneinander angrenzen oder einander überlappen.

Entsprechend einer bevorzugten Ausführungsform einer Lötstoppbarriere weist diese eine innere, eine äußere und eine mittlere Lötstoppspur auf, wobei die innere Lötstoppspur zwischen der äußeren Lötstoppspur und der vorgesehenen Lötfläche verläuft, und wobei die mittlere Lötstoppspur zwischen der äußeren und der inneren Lötstoppspur verläuft.

Wenn sich dabei die mittlere Lötstoppspur sowohl mit der inneren als auch mit der äußeren Lötstoppspur überlappt, ist es gemäß einer besonders bevorzugten Ausführungsform des erfindungsgemäßen Verfahrens vorteilhaft, wenn zunächst die innere Lötstoppspur hergestellt wird, anschließend die äußere und zum Schluss die mittlere Lötstoppspur.

Erfindungsgemäß hergestellte Lötstoppbarrieren werden bevorzugt bei der Lötung metallisierter Substrate auf ganzflächig benetzenden Oberflächen eines Trägers eingesetzt. Die metallisierten Substraten sind vorzugsweise mit elektronischen Bauelementen, insbesondere Leistungshalbleiterbauelementen, bestückt.

Der Träger ist dabei bevorzugt als ebene Platte ausgebildet und kann außerdem eine Beschichtung, beispielsweise eine galvanische Beschichtung, aufweisen.

Der Träger selbst oder ein Teil davon kann wahlweise als Isolator, zum Beispiel aus keramischem Material, als Halbleiter, zum Beispiel aus Silizium, oder als Leiter, zum Beispiel aus Kupfer oder einer Kupferlegierung, gebildet sein. Dabei ist es häufig von Bedeutung, dass das Trägermaterial eine gute Wärmeleitfähigkeit aufweist, um die beim Betrieb von auf den Träger gelöteten elektronischen Komponenten entstehende Wärme hinreichend abzuleiten.

Die Beschichtung des Trägers kann eine oder mehrere Teilschichten aufweisen. Dabei ist die Beschichtung oder wenigstens die dem Kern des Trägers abgewandte Teilschicht wenigstens abschnittweise lötfähig und elektrisch leitend.

Der Träger weist vorzugsweise eine Metallisierung auf, die beispielsweise mittels galvanischer Abscheidung erzeugt werden kann. Gemäß einer bevorzugten Ausführungsform ist der Träger aus Kupfer oder einer Kupferlegierung gebildet, während die Beschichtung zumindest teilweise aus Nickel oder einer Nickellegierung besteht.

Die Erfindung wird nachfolgend anhand von bevorzugten Ausführungsbeispielen unter Bezugnahme auf die Figuren näher erläutert. Es zeigen:
- Figur 1: ein Ausführungsbeispiel einer Lötstoppbarriere ge- mäß dem Stand der Technik mit noch nicht verlaufe- nem Lot im Querschnitt,
- Figur 2: das Ausführungsbeispiel gemäß dem Stand der Tech- nik nach Figur 1, jedoch mit verlaufenem Lot im Querschnitt,
- Figur 3: mehrere Schritte eines erfindungsgemäßen Verfah- rens zur Herstellung einer Lötstoppbarriere in perspektivischer Ansicht,
- Figur 4: verschiedene Ansichten eines eine erfindungsgemäße Lötstoppbarriere aufweisenden Trägers in unter- schiedlichen Bestückungszuständen,
- Figur 5: einen Träger mit zwei jeweils zwei Lötstoppspuren aufweisende, als geschlossene Kurven ausgebildete Lötstoppbarrieren in Draufsicht,
- Figur 6: einen Träger, dessen Oberseite mittels zweier Löt- stoppbarrieren in drei Abschnitte aufgeteilt ist, in Draufsicht,
- Figur 7: einen Träger, auf den mittels eines Lotes ein Sub- strat aufgelötet ist sowie mit einer Lötstoppbar- riere, die das Abfließen des Lotes in einer Rich- tung verhindert, in Draufsicht,
- Figur 8: einen Träger mit einer Lötstoppbarriere, die drei parallel zueinander verlaufende Lötstoppspuren aufweist, welche in einer vorgegebenen Reihenfolge hergestellt werden, in Draufsicht,
- Figur 9: einen Linien-Scan der Oberfläche eines Trägers quer zu einer Lötstoppspur, und

In den Figuren bezeichnen gleiche Bezugszeichen gleiche Teile mit gleicher Bedeutung.

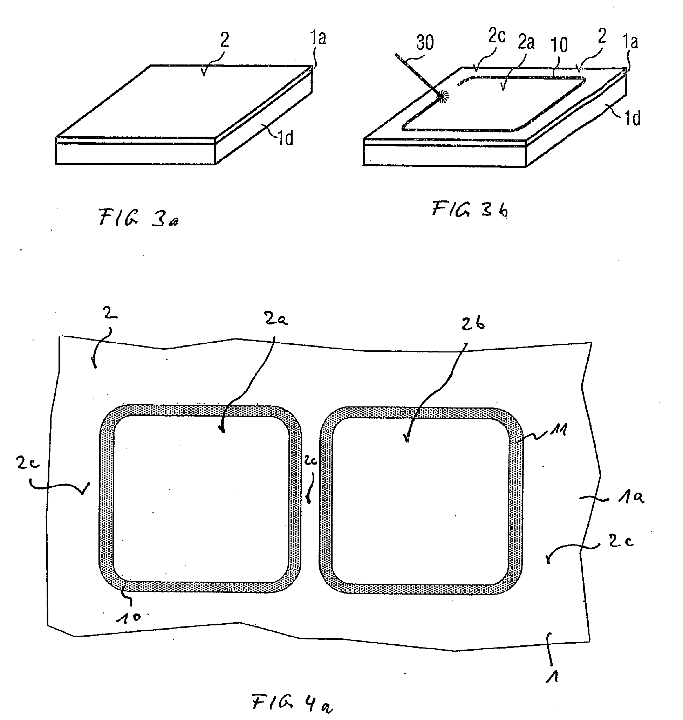

Figur 3 zeigt mehrere Schritte eines erfindungsgemäßen Verfahrens zur Herstellung einer Lötstoppbarriere in perspektivischer Ansicht. Dabei wird, wie in Figur 3a gezeigt, zunächst ein Träger 1 bereitgestellt. In dem hier gezeigten Ausführungsbeispiel umfasst der Träger 1 einen Grundkörper 1d, der beispielsweise aus Keramik, z.B. aus Siliziumkarbid, oder aus Kupfer gebildet sein kann.

Der Grundkörper 1d ist gemäß einer bevorzugten Ausführungsform einfach oder mehrfach beschichtet. Die oberste dieser Schichten wird im Folgenden als Deckschicht bezeichnet und ist mit dem Bezugszeichen 1a versehen. Diese Deckschicht 1a ist lötfähig, bevorzugt elektrisch leitend und umfasst ein oder mehrere chemische Elemente, beispielsweise Nickel, Kupfer oder Titan. Die bevorzugte Dicke der Deckschicht 1a beträgt 8 µm bis 18 µm.

Gemäß eines weiteren bevorzugten Ausführungsbeispiels eines Trägers 1 umfasst dieser einen Grundkörper 1d aus SiliziumCarbid (SiC) gefolgt von einer Schicht aus Aluminium sowie einer Deckschicht 1a aus Nickel.

In einem zweiten Schritt wird auf der Oberfläche 2, wie in Figur 3b gezeigt, durch die Einwirkung eines Laserstrahls 30 eine erfindungsgemäße Lötstoppbarriere 10 erzeugt. Die Lötstoppbarriere 10 wir gemäß einer bevorzugten Ausführungsform der Erfindung als geschlossene Kurve hergestellt. Sie umschließt eine vorgesehene Lötfläche 2a und trennt diese gegenüber einem Bereich 2c der Oberfläche 2, der nicht mit Lot benetzt werden soll.

Durch die Einwirkung des Laserstrahls 30 wird dem Träger 1 an seiner Oberfläche 2 Energie zugeführt, wodurch es lokal zu einer Reaktion zwischen bestimmten Materialien des Trägers 1 und einer den Träger 1 umgebenden Atmosphäre kommt. Hierdurch verändert sich bei geeigneter Wahl der Reaktionspartner die Oberfläche 2 des Trägers in dem bestrahlten Bereich derart, dass sich ihre Benetzbarkeit mit flüssigem Lot verglichen mit dem unbestrahlten Träger 1 reduziert.

Bei der beschriebenen Reaktion handelt es sich bevorzugt um eine Oxidation von an der Oberfläche 2 befindlichem Trägermaterial im Bereich von der mit dem Laserstrahl 30 gezogenen Spur 10. Infolge der reduzierten Benetzbarkeit der Trägeroberfläche 2 im Bereich der Spur 10 wird flüssiges Lot, das sich auf einer Seite der Spur 10 auf der Oberfläche 2 des Trägers 1 ausbreitet, an der Spur 10 gestoppt. Eine einzelne von einem Laserstrahl 30 gezogene Spur wird daher im folgenden auch als Lötstoppspur bezeichnet. Gemäß einer bevorzugten Ausführungsform der Erfindung können auch zwei oder mehr Lötstoppspuren parallel zueinander verlaufen. Die Gesamtheit aller Lötstoppspuren, die entlang eines Pfades ein Hindernis für flüssiges Lot bilden, wird nachfolgend als Lötstoppbarriere bezeichnet. Beim Ausführungsbeispiel gemäß Figur 3b liegt eine Lötstoppbarriere 10 vor, die identisch ist mit der Lötstoppspur 10.

Die Lötstoppbarriere 10 ist vorzugsweise als geschlossene Kurve ausgebildet und umschließt einen Abschnitt 2a der Oberfläche 2, der mit flüssigem Lot bedeckt werden soll. Ein auf den Abschnitt 2a der Oberfläche 2 aufzubringendes flüssiges Lot wird durch die Lötstoppbarriere 10 darin gehindert, auf einen Abschnitt 2c der Oberfläche 2, der nicht mit Lot bedeckt werden soll, hinüberzufließen.

Figur 4a zeigt eine Draufsicht auf einen Träger 1, dessen Oberfläche 2 zwei Lötstoppbarrieren 10, 11 aufweist, die entsprechend der Lötstoppbarriere 10 gemäß Figur 3b ausgebildet sind und jeweils eine Lötstoppspur aufweisen. Die Lötstoppbarrieren 10, 11 umschließen Abschnitte 2a bzw. 2b der Oberfläche 2 des Trägers 1, auf die jeweils ein Substrat aufgelötet werden soll. Hierzu ist es vorgesehen, auf die Abschnitte 2a, 2b Lot aufzubringen, während die außerhalb der die Abschnitte 2a, 2b umschließenden Lötstoppbarrieren 10, 11 angeordneten Abschnitte 2c der Oberfläche 2 nicht mit Lot bedeckt werden sollen.

Nach der Herstellung der Lötstoppbarrieren 10, 11 wird ein Lot auf die Abschnitte 2a, 2b aufgebracht. Das Lot kann auf die Abschnitte 2a, 2b entweder in fester Form oder in Pastenform aufgebracht und anschließend geschmolzen oder aber bereits in flüssiger Form aufgebracht werden.

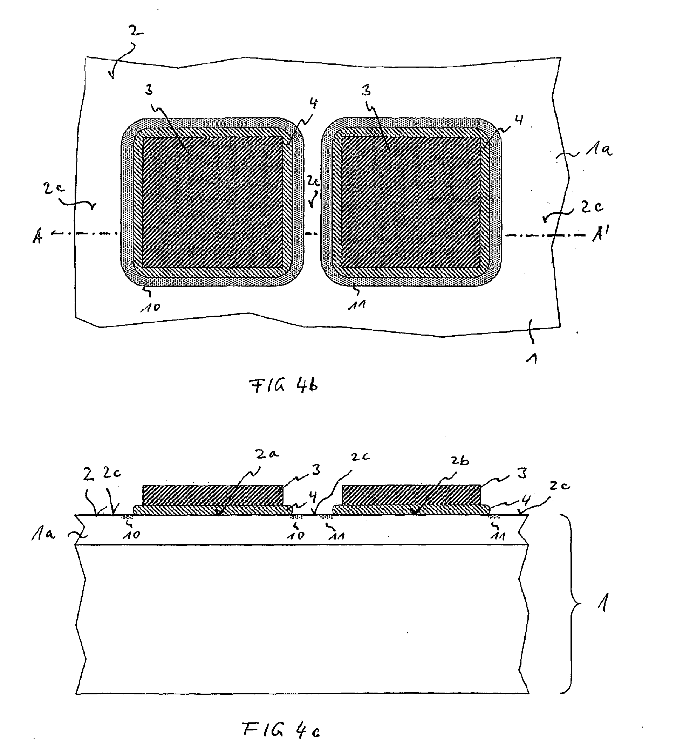

Figur 4b zeigt die Anordnung gemäß Figur 4a mit Substraten 3, die mittels Lot 4 auf die Abschnitte 2a, 2b der Oberfläche 2 gelötet sind. Die Abschnitte 2c der Oberfläche 2 sind nicht mit Lot bedeckt.

Eine Schnittansicht durch eine Ebene A-A' ist in Figur 4c gezeigt. Hierbei ist zu erkennen, dass der Verlauf der Oberfläche 2 gemäß einer bevorzugten Ausführungsform der Erfindung durch die Herstellung der Lötstoppbarrieren 10, 11, d.h. durch die Einwirkung des Laserstrahls, im Wesentlichen unverändert ist. Ein Abtrag des Trägermaterials durch die Einwirkung des Laserstrahls soll weitestgehend vermieden werden. Die Dicke der an der Oberfläche 2 hergestellten Lötstoppbarrieren 10, 11 ist in Figur 4c nicht maßstäblich sondern überhöht dargestellt.

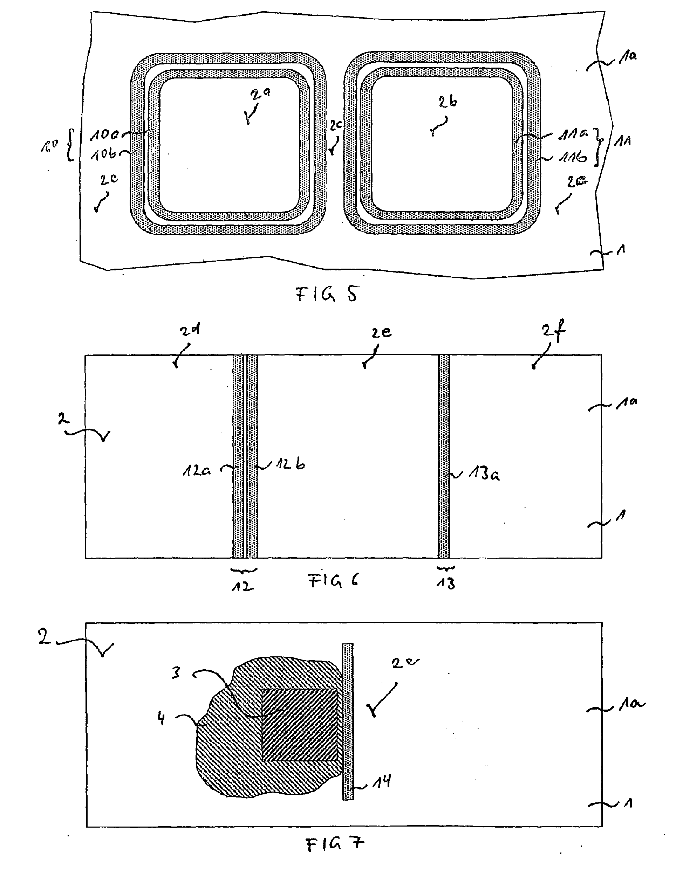

Figur 5 zeigt eine Ansicht entsprechend Figur 4a, wobei im Unterschied dazu die Lötstoppbarrieren 10, 11 aus jeweils zwei parallel zueinander verlaufenden Lötstoppspuren 10a, 10b bzw. 11a, 11b gebildet sind. In entsprechender Weise kann eine Lötstoppbarriere 10, 11 auch drei oder mehr Lötstoppspuren 10a, 10b 11a, 11b umfassen.

Die einzelnen Lötstoppspuren 10a, 10 b bzw. 11a, 11b einer Lötstoppbarriere 10 bzw. 11 können dabei voneinander beabstandet sein, aneinander grenzen oder einander überlappen.

Wie in den Figuren 6 und 7 gezeigt, muss eine Lötstoppbarriere 10, 11 nicht notwendigerweise als geschlossene Kurve ausgebildet sein. In Figur 6 ist beispielsweise dargestellt, dass die Oberfläche 2 eines Trägers 1 mittels zweier erfindungsgemäßer Lötstoppbarrieren 12, 13 in verschiedene Abschnitte 2d, 2e aufgeteilt werden kann, ohne dass die Lötstoppbarrieren 12, 13 als geschlossene Kurven ausgebildet sind. In diesem Ausführungsbeispiel ist die Lötstoppbarriere 12 aus zwei Lötstoppspuren 12a, 12b gebildet, während die Lötstoppbarriere 13 lediglich eine Lötstoppspur 13a umfasst. Gemäß einer bevorzugten Ausführungsform der Erfindung verlaufen die Lötstoppbarrieren 12, 13 zwischen zwei einander gegenüberliegenden Seiten der Oberfläche 2 des Trägers 1.

Ein weiteres Ausführungsbeispiel einer nicht als geschlossene Kurve ausgebildeten Lötstoppbarriere zeigt Figur 7. Auf der Oberfläche 2 des Trägers 1 wurde zunächst in der beschriebenen Weise eine Lötstoppspur 14 erzeugt. Die Lötstoppspur 14 erstreckt sich lediglich abschnittweise auf der Oberfläche 2. Auf einer Seite der Lötstoppspur 14 soll ein Substrat 3 auf die Oberfläche 2 des Trägers 1 aufgelötet werden. Die Lötstoppspur 14 soll verhindern, dass das hierzu verwendete Lot 4 während des Lötvorgangs in einen Abschnitt 2c der Oberfläche 2 verläuft, der nicht mit Lot bedeckt werden soll.

Auf der dem Abschnitt 2c abgewandten Seite der Oberfläche 2 kann überschüssiges, unter dem Substrat 3 befindliches Lot 4 seitlich abfließen, so dass die nach dem Erstarren des flüssigen Lotes 4 durch diese gebildete Verbindungsschicht zwischen dem Substrat 3 der Oberfläche 2 möglichst dünn ausgebildet ist. Insbesondere wenn auf einem derartigen Substrat 3 elektrische Bauelemente (nicht dargestellt) wie z.B. Leistungshalbleiterbauelemente angeordnet sind, in denen eine hohe Verlustwärme erzeugt wird, ist eine Lötverbindung mit geringer Dicke von Vorteil, da die Verlustwärme wegen des damit verbundenen niedrigen Wärmeübergangswiderstandes besser abgeführt werden kann.

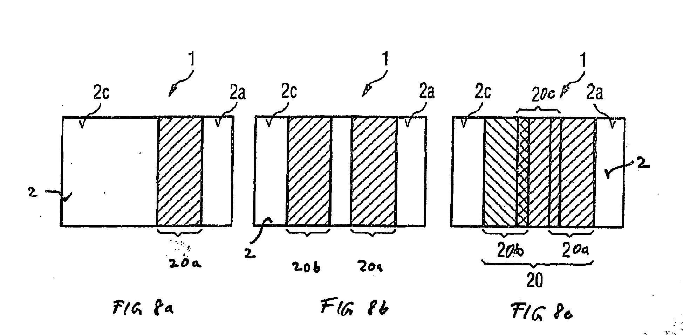

Wie oben erwähnt, kann eine erfindungsgemäße Lötstoppbarriere mehrere Lötstoppspuren aufweisen. Dabei verlaufen die Lötstoppspuren bevorzugt parallel zueinander. Unter anderem ist es daher vorgesehen, dass zwei oder mehr Lötstoppspuren einander ganz oder teilweise überlagern. Die Figuren 8a, 8b und 8c zeigen ein Verfahren zur Herstellung einer Lötstoppbarriere 20, die aus Lötstoppspuren 20a, 20b und 20c gebildet ist.

Wie in Figur 8 gezeigt ist, wird dabei nach dem Bereitstellen eines Trägers 1 auf dessen Oberfläche 2 zunächst eine Lötstoppbarriere hergestellt, die einen Abschnitt 2a der Oberfläche 2, der mit Lot benetzt werden soll, von einem Anschnitt 2c der Oberfläche 2, der nicht mit Lot benetzt werden soll, trennt.

Dazu wird zunächst gemäß Figur 8a in der beschriebenen Weise eine innere Lötstoppspur 20a hergestellt. Die innere Lötstoppspur 20a ist diejenige Lötstoppspur der herzustellenden Lötstoppbarriere, die dem mit Lot zu benetzenden Abschnitt 2a am nächsten liegt.

Als nächstes wird, wie im Ergebnis in Figur 8b gezeigt, eine äußere Lötstoppspur 20b hergestellt, die parallel zur inneren Lötstoppspur 20a verläuft. Die Lötstoppspuren 20a, 20b können sowohl - wie in Figur 8b dargestellt - voneinander beabstandet sein, als auch aneinander angrenzen oder einander überlappen. Die äußere Lötstoppspur 20b ist die vom Abschnitt 2a am weitesten beabstandete Lötstoppspur der herzustellenden Lötstoppbarriere 20.

Anschließend wird eine mittlere Lötstoppspur 20c erzeugt, die parallel zur inneren bzw. äußeren Lötstoppspur 20a bzw. 20b verläuft und die sich mit jeder von diesen teilweise überlappt. Das Ergebnis ist in Figur 8c dargestellt. Die Lötstoppspuren 20a, 20b, 20c bilden zusammen die Lötstoppbarriere 20.

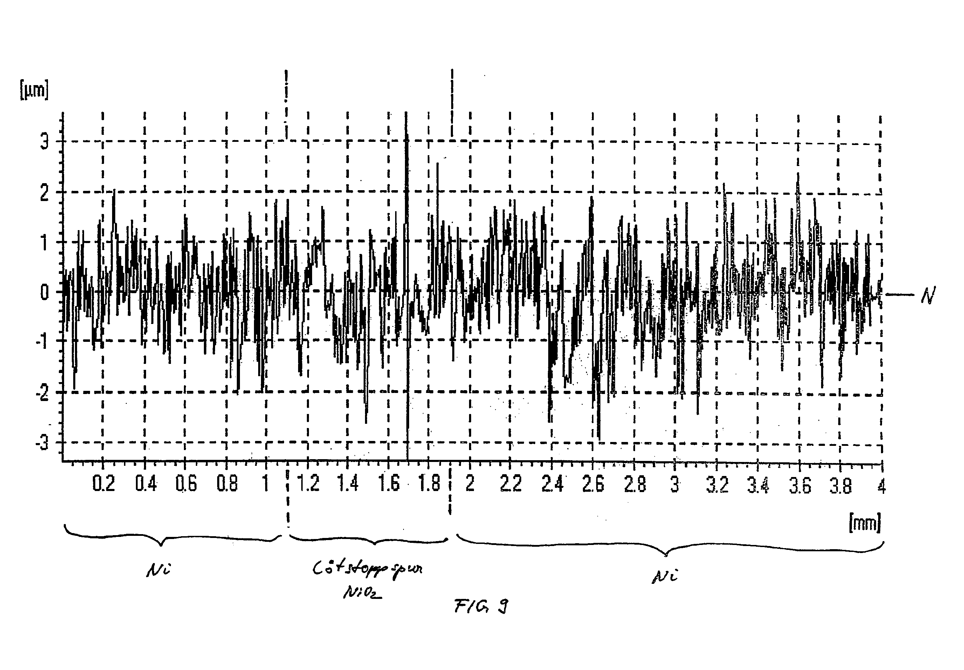

Figur 9 zeigt einen gemessenen Linien-Scan von der Oberfläche eines Trägers, der einen mit Nickel beschichteten Grundkörper aus Kupfer aufweist, und gibt den Verlauf des Oberflächen-Niveaus der Nickelbeschichtung wieder, das bei 0 µm liegt. Der Linien-Scan verläuft quer zu einer auf der NickelBeschichtung mittels Einwirkung eines Laserstrahls erzeugten, erfindungsgemäßen Lötstoppbarriere, weist eine Auflösung von 500 Abtastpunkten/mm (entspricht einem Abtastpunktabstand von 2 µm) auf und erstreckt sich über eine Distanz von 4 mm. Bei diesem Ausführungsbeispiel ist die Lötstoppbarriere aus Nickeloxid (NiO) gebildet, das infolge einer laserstrahlinduzierten Oxidation der Nickelbeschichtung mit Sauerstoff aus der Umgebungsluft entstanden ist.

Eine Beschichtung kann neben Nickel auch aus anderen Elementen wie z.B. Kupfer und/oder Titan oder aus einer Legierung mit wenigstens einem dieser Elemente gebildet sein. Eine durch Oxidation erzeugte Lötstoppspur ist dann entsprechend aus Nickeloxid und/oder Kupferoxid und/oder Titanoxid gebildet.

Die Lötstoppbarriere erstreckt sich in diesem Ausführungsbeispiel über den Bereich zwischen ca. 1,1 mm und ca. 1,9 mm, weist also eine Breite von ca. 0,8 mm auf und umfasst vier aneinandergrenzende Lötstoppspuren mit einer Breite von jeweils ca. 0,2 mm. Die Breite einer Lötstoppspur kann prinzipiell beliebig gewählt werden, sie ist nicht auf die oben genannten Werte beschränkt, beträgt jedoch bevorzugt zwischen 10 µm und 1000 µm, besonders bevorzugt zwischen 150 µm und 250 µm.

Dem Linien-Scan ist zu entnehmen, dass zwischen der Oberflächenrauhigkeit im Bereich der Lötstoppbarriere und der Oberflächenrauhigkeit im Bereich neben der Lötstoppbarriere kein signifikanter Unterschied besteht. Die Lötstoppbarriere bzw. die Lötstoppspur wurde damit vertiefungsfrei oder im Wesentlichen vertiefungsfrei an der Oberfläche des Trägers erzeugt. Der RMS-Wert (RMS = Root Mean Square) des Oberflächen-Niveaus bezogen auf dessen Mittelwert beträgt sowohl im Bereich der Lötstoppbarriere als auch in den daneben liegenden Bereichen ca. 1,5 µm.

### Bezugszeichenliste

- 1: Träger
- 1a: Deckschicht des Trägers
- 1d: Grundkörper des Trägers
- 2: Trägeroberfläche
- 2a, 2b: Lötfläche auf der Trägeroberfläche
- 2c: Trägeroberfläche, die nicht von Lot benetzt werden soll
- 3, 3a, 3b: Substrat
- 4: Lot
- 5: Lötstopplack
- 10, 11, 12, 13: Lötstoppbarriere
- 14, 15, 16, 20: Lötstoppbarriere
- 10a, 10b, 11a, 11b: Lötstoppspur
- 12a, 12b, 13a: Lötstoppspur
- 20a: innere Lötstoppspur
- 20b: äußere Lötstoppspur
- 20c: mittlere Lötstoppspur
- 30: Laserstrahl
- N1: mittleres Oberflächen-Niveau vor dem Herstellen der Lötstoppspur
- N2: mittleres Oberflächen-Niveau im Bereich der Lötstoppspur
- t: Absenkung des mittleren Oberflächen- Niveaus im Bereich der Lötstoppspur

## Patentansprüche

1. Verfahren zur Herstellung einer Lötstoppbarriere (10-16, 20), die wenigstens eine Lötstoppspur (10a, 10b, 11a 11b 12a, 12b, 13a) aufweist, die zumindest abschnittweise um eine auf dem Träger (1) abzugrenzende Lötfläche (2a, 2b) herum angeordnet ist, mit folgenden Schritten:
Bereitstellen eines Trägers (1); und
Herstellen der wenigstens einen Lötstoppspur (10a, 10b, 11a, 11b, 12a, 12b, 13a), indem an der Oberfläche (2) des Trägers (1) durch Einwirkung eines Laserstrahls (30) entlang eines Pfades eine chemische Veränderung herbeigeführt wird, die die Benetzbarkeit der Oberfläche (2) des Trägers (1) mit flüssigem Lot (4) im Bereich des Pfades lokal reduziert;
**dadurch gekennzeichnet, dass**
die wenigstens eine Lötstoppspur (10a, 10b, 11a, 11b, 12a, 12b, 13a) vertiefungsfrei in der Oberfläche (2) des Trägers (1) hergestellt wird.

2. Verfahren nach Anspruch 1,
bei dem die chemische Veränderung darin besteht, dass wenigstens zwei chemische Stoffe miteinander reagieren.

3. Verfahren nach Anspruch 2,
bei dem zumindest einer der wenigstens zwei chemischen Stoffe dem Material des Trägers (1) entstammt.

4. Verfahren nach Anspruch 2 oder 3,
bei dem zumindest einer der wenigstens zwei chemischen Stoffe einer den Träger (1) umgebenden Atmosphäre entstammt.

5. Verfahren nach Anspruch 4,
bei dem die den Träger (1) umgebende Atmosphäre Luft ist.

6. Verfahren nach einem der vorangehenden Ansprüche,
bei dem die chemische änderung eine Oxidation ist.

7. Verfahren nach einem der vorangehenden Ansprüche,
bei dem die Lötstoppbarriere (10, 11, 20) oder wenigstens eine Lötstoppspur (10a, 10b) als geschlossene Kurve hergestellt wird.

8. Verfahren nach einem der vorangehenden Ansprüche,
bei dem zur Herstellung der Lötstoppbarriere (10; 11; 12; 20) wenigstens zwei zumindest abschnittweise parallel verlaufende Lötstoppspuren (10a, 10b; 11a, 11b; 12a, 12b; 20a, 20b, 20c) erzeugt werden.

9. Verfahren nach einem der vorangehenden Ansprüche,
bei dem zur Herstellung der Lötstoppbarriere (20) wenigstens zwei zumindest abschnittweise aneinandergrenzende Lötstoppspuren erzeugt werden.

10. Verfahren nach einem der vorangehenden Ansprüche,
bei dem zur Herstellung der Lötstoppbarriere (10, 11, 12, 20) wenigstens zwei zumindest abschnittweise voneinander beabstandete Lötstoppspuren (10a, 10b; 11a, 11b; 12a, 12b; 20a, 20c) erzeugt werden.

11. Verfahren nach einem der vorangehenden Ansprüche,
bei dem zur Herstellung der Lötstoppbarriere (20) wenigstens zwei sich zumindest abschnittweise überlagernde Lötstoppspuren (20a, 20b, 20c) erzeugt werden.

12. Verfahren nach Anspruch 11
mit einer inneren (20a), einer äußeren (20b) und einer mittleren (20c) Lötstoppspur , wobei
die innere Lötstoppspur (20a) zwischen der äußeren Lötstoppspur (20b) und der Lötfläche (2a) verläuft,
die mittlere Lötstoppspur (20c) zwischen der äußeren Lötstoppspur (2b) und der inneren Lötstoppspur (20a) verläuft, und
zunächst die innere (20a), dann die äußere (20b) und anschließend die mittlere (20c) Lötstoppspur hergestellt wird.

13. Verfahren nach Anspruch 12,
bei sich die mittlere Lötstoppspur (20c) mit der inneren Lötstoppspur (20a) und/oder mit der äußeren Lötstoppspur (20b) wenigstens abschnittweise überlagert.

14. Verfahren nach einem der vorangehenden Ansprüche,
bei dem zumindest eine Lötstoppspur (10a, 10b, 11a, 11b, 12a, 12b, 13a, 20a, 20b, 20c) eine Breite zwischen 10 µm und 1000 µm aufweist.

15. Verfahren nach Anspruch 14,
bei dem zumindest eine Lötstoppspur (10a, 10b, 11a, 11b, 12a, 12b, 13a, 20a, 20b, 20c) eine Breite zwischen 150 µm und 250 µm aufweist.

16. Verfahren nach einem der vorangehenden Ansprüche,
bei dem das Material des Trägers (1) durch die Einwirkung des Laserstrahls (30) vorübergehend aufgeschmolzen wird.

17. Verfahren nach einem der vorangehenden Ansprüche,
bei dem der Träger (1) als ebene Platte ausgebildet ist.

18. Verfahren nach einem der vorangehenden Ansprüche,
bei dem der Träger (1) wenigstens auf einem Abschnitt seiner Oberfläche (2) eine metallische Beschichtung (1a) aufweist.

19. Verfahren nach Anspruch 18,
bei dem die metallische Beschichtung (1a) Nickel und/oder Kupfer und/oder Titan oder einer Legierung mit wenigstens einem dieser Elemente umfasst.

20. Verfahren nach einem der vorangehenden Ansprüche,
bei dem die wenigstens eine Lötstoppspur (10a, 10b, 11a, 11b, 12a, 12b, 13a, 20a, 20b, 20c) aus Nickeloxid und/oder Kupferoxid und/oder Titanoxid gebildet wird.

## Claims

1. Method for producing a solder stop barrier (10-16, 20) which comprises at least one solder stop track (10a, 10b, 11a, 11b, 12a, 12b, 13a) arranged at least in certain portions around a soldering surface (2a, 2b) to be delimited on the support (1), said method comprising the following steps:
a support (1) is provided; and
the at least one solder stop track (10a, 10b, 11a, 11b 12a, 12b, 13a) is produced by inducing a chemical modification on the surface (2) of the support (1) by the action of a laser beam (30) along a path, said chemical modification locally reducing the wettability of the surface (2) of the support (1) with liquid solder (4) in the region of the path;
**characterized in that**
the at least one solder stop track (10a, 10b, 11a, 11b, 12a, 12b, 13a) is produced in the surface (2) of the support (1) in a recess-free manner.

2. Method according to Claim 1,
wherein the chemical modification consists in the reaction of at least two chemical substances with one another.

3. Method according to Claim 2,
wherein at least one of the at least two chemical substances originates from the material of the support (1).

4. Method according to Claim 2 or 3,
wherein at least one of the at least two chemical substances originates from an atmosphere surrounding the support (1).

5. Method according to Claim 4,
wherein the atmosphere surrounding the support (1) is air.

6. Method according to one of the preceding claims,
wherein the chemical modification is oxidation.

7. Method according to one of the preceding claims,
wherein the solder stop barrier (10, 11, 20) or at least one solder stop track (10a, 10b) is produced as a continuous curve.

8. Method according to one of the preceding claims,
wherein the solder stop barrier (10; 11; 12; 20) is produced by creating at least two solder stop tracks (10a, 10b; 11a, 11b 12a, 12b; 20a, 20b, 20c) which extend in parallel at least in certain portions.

9. Method according to one of the preceding claims,
wherein the solder stop barrier (20) is produced by creating at least two solder stop tracks which adjoin one another at least in certain portions.

10. Method according to one of the preceding claims,
wherein the solder stop barrier (10, 11, 12, 20) is produced by creating at least two solder stop tracks (10a, 10b; 11a, 11b; 12a, 12b; 20a, 20c) which are spaced apart from one another at least in certain portions.

11. Method according to one of the preceding claims,
wherein the solder stop barrier (20) is produced by creating at least two solder stop tracks (20a, 20b, 20c) which are superimposed at least in certain portions.

12. Method according to Claim 11,
with an inner solder stop track (20a), an outer solder stop track (20b) and a central solder stop track (20c), wherein
the inner solder stop track (20a) extends between the outer solder stop track (20b) and the soldering surface (2a),
the central solder stop track (20c) extends between the outer solder stop track (2b) and the inner solder stop track (20a), and
firstly the inner solder stop track (20a), then the outer solder stop track (20b) and subsequently the central solder stop track (20c) are produced.

13. Method according to Claim 12,
wherein the central solder stop track (20c) overlaps at least in certain portions with the inner solder stop track (20a) and/or with the outer solder stop track (20b).

14. Method according to one of the preceding claims,
wherein at least one solder stop track (10a, 10b, 11a, 11b, 12a, 12b, 13a, 20a, 20b, 20c) has a width of between 10 µm and 1000 µm.

15. Method according to Claim 14,
wherein at least one solder stop track (10a, 10b, 11a, 11b, 12a, 12b, 13a, 20a, 20b, 20c) has a width of between 150 µm and 250 µm.

16. Method according to one of the preceding claims,
wherein the material of the support (1) is temporarily melted by the action of the laser beam (30).

17. Method according to one of the preceding claims,
wherein the support (1) is in the form of a planar plate.

18. Method according to one of the preceding claims,
wherein at least a portion of the surface (2) of the support (1) is provided with a metallic coating (1a).

19. Method according to Claim 18,
wherein the metallic coating (1a) comprises nickel and/or copper and/or titanium or an alloy containing at least one of these elements.

20. Method according to one of the preceding claims,
wherein the at least one solder stop track (10a, 10b, 11a 11b, 12a, 12b, 13a, 20a, 20b, 20c) is formed from nickel oxide and/or copper oxide and/or titanium oxide.

## Revendications

1. Procédé de production d'une barrière (10 à 16, 20) d'arrêt de soudure, qui comporte au moins une trace (10a, 10b, 11a, 11b, 12a, 12b, 13a) d'arrêt de soudure, disposée au moins par segment autour d'une surface (2a, 2b) de soudure du support (1), comprenant les stades suivants :
on se procure un support (1) ; et
on produit une trace (10a, 10b, 11a, 11b, 12a, 12b, 13a) d'arrêt de soudure en provoquant une modification chimique sur la surface (2) du support (1) par action d'un faisceau (30) laser le long d'un trajet, modification qui réduit localement dans la zone du trajet la mouillabilité de la surface (2) du support (1) par de la soudure (4) liquide ;
**caractérisé en ce que**
on produit la au moins une trace (10a, 10b, 11a, 11b, 12a, 12b, 13a) d'arrêt de soudure sans profondeur dans la surface (2) du support (1).

2. Procédé suivant la revendication 1,
dans lequel la modification chimique consiste dans le fait qu'on fait réagir entre elles au moins deux substances chimiques.

3. Procédé suivant la revendication 2,
dans lequel au moins l'une des au moins deux substances chimiques provient du matériau du support (1).

4. Procédé suivant la revendication 2 ou 3,
dans lequel au moins l'une des au moins deux substances chimiques provient d'une atmosphère entourant le support (1).

5. Procédé suivant la revendication 5,
dans lequel l'atmosphère entourant le support (1) est l'air.

6. Procédé suivant l'une des revendications précédentes,
dans lequel la modification chimique est une oxydation.

7. Procédé suivant l'une des revendications précédentes,
dans lequel on produit la barrière (10, 11, 20) d'arrêt de soudure ou au moins une trace (10a, 10b, 11a, 11b, 12a, 12b, 13a) d'arrêt de soudure sous la forme d'une courbe fermée.

8. Procédé suivant l'une des revendications précédentes,
dans lequel, pour la production de la barrière (10, 11, 12, 20) d'arrêt de soudure, on produit au moins deux traces (10a, 10b, 11a, 11b, 12a, 12b, 20a, 20b, 20c) d'arrêt de soudure s'étendant parallèlement au moins par segment.

9. Procédé suivant l'une des revendications précédentes,
dans lequel, pour la production de la barrière (20) d'arrêt de soudure, on produit au moins deux traces d'arrêt de soudure voisines l'une de l'autre au moins par segment.

10. Procédé suivant l'une des revendications précédentes,
dans lequel, pour la production de la barrière (10, 11, 12, 20) d'arrêt de soudure, on produit au moins deux traces (10a, 10b, 11a, 11b, 12a, 12b, 20a, 20b, 20c) d'arrêt de soudure à distance l'une de l'autre au moins par segment.

11. Procédé suivant l'une des revendications précédentes,
dans lequel pour la production de la barrière (20) d'arrêt de soudure, on produit au moins deux traces (20a, 20b, 20c) d'arrêt de soudure se superposant au moins par segment.

12. Procédé suivant la revendication 11,
comprenant une trace (20a) intérieure d'arrêt de soudure, une trace (20b) extérieure d'arrêt de soudure et une trace (20c) médiane d'arrêt de soudure, dans lequel
la trace (20a) intérieure d'arrêt de soudure s'étend entre la trace (20b) extérieure d'arrêt de soudure et la surface (2a) de soudure,
la trace (20c) médiane d'arrêt de soudure s'étend entre la trace (20b) extérieure d'arrêt de soudure et la trace (20a) intérieure d'arrêt de soudure, et
on produit d'abord la trace (20a) intérieure d'arrêt de soudure, puis la trace (20b) extérieure d'arrêt de soudure et ensuite la trace (20c) médiane d'arrêt de soudure.

13. Procédé suivant la revendication 12,
dans lequel la trace (20c) médiane d'arrêt de soudure est superposée au moins par segment à la trace (20a) intérieure d'arrêt de soudure et/ou à la trace (20b) extérieure d'arrêt de soudure.

14. Procédé suivant l'une des revendications précédentes,
dans lequel au moins une trace (10a, 10b, 11a, 11b, 12a, 12b, 13a, 20a, 20b, 20c) d'arrêt de soudure a une largeur comprise entre 10 µm et 1 000 µm.

15. Procédé suivant la revendication 14,
dans lequel au moins une trace (10a, 10b, 11a, 11b, 12a, 12b, 13a, 20a, 20b, 20c) d'arrêt de soudure a une largeur comprise entre 150 µm et 250 µm.

16. Procédé suivant l'une des revendications précédentes,
dans lequel on fait fondre temporairement le matériau du support (1) par l'action du faisceau (30) laser.

17. Procédé suivant l'une des revendications précédentes,
dans lequel on constitue le support (1) sous la forme d'une plaque plane.

18. Procédé suivant l'une des revendications précédentes,
dans lequel le support (1) a un revêtement (1a) métallique, au moins sur une partie de sa surface (2).

19. Procédé suivant la revendication 18,
dans lequel le revêtement (1a) métallique comprend du nickel et/ou du cuivre et/ou du titane ou un alliage d'au moins l'un de ces éléments.

20. Procédé suivant l'une des revendications précédentes,
dans lequel la au moins une trace (10a, 10b, 11a, 11b, 12a, 12b, 13a, 20a, 20b, 20c) d'arrêt de soudure est en oxyde de nickel et/ou en oxyde de cuivre et/ou en oxyde de titane.
